# EUROPÄISCHE PATENTSCHRIFT

(11) **EP 3 569 042 B1**
(45) Veröffentlichungstag und Bekanntmachung des Hinweises auf die Patenterteilung: **03.05.2023**
(21) Anmeldenummer: 18700324.9
(22) Anmeldetag: 10.01.2018
(51) Int. Cl.: H05K 7/14, H01R 9/26, H02B 1/052

(54) **ELEKTRONIKMODUL UND MONTAGEBASIS MIT EINEM ELEKTRONIKMODUL**
ELECTRONICS MODULE, AND A MOUNTING BASE COMPRISING AN ELECTRONICS MODULE
MODULE ÉLECTRONIQUE ET BASE DE MONTAGE COMPORTANT UN MODULE ÉLECTRONIQUE

(30) Priorität: 13.01.2017 DE 202017100172 U
(43) Veröffentlichungstag der Anmeldung: 20.11.2019
(73) Patentinhaber: Weidmüller Interface GmbH & Co. KG, 32758 Detmold (DE)
(72) Erfinder: SCHUMACHER, Ralf, 32657 Lemgo (DE)
(74) Vertreter: Specht, Peter
(86) Internationale Anmeldenummer: PCT/EP2018/050520
(87) Internationale Veröffentlichungsnummer: WO 2018/130547

(56) Entgegenhaltungen:
- DE-A1- 2 719 194
- DE-B- 1 201 447
- DE-B2- 2 719 194
- US-A- 3 160 280
- US-A1- 2005 175 402

## Beschreibung

Die Erfindung betrifft ein Elektronikmodul nach dem Oberbegriff des Anspruchs 1 und eine Anordnung aus einer Montagebasis mit einer Tragschiene und Elektronikmodulen.

Zum Stand der Technik wird die DE 27 19 194 A1 D1 genannt, die eine federnde Abstützung eines Schalters mit Feder- und Raststegen in einer Aufnahme eines Aufnahmeteils offenbart. Der Schalter weist an seinen Seiten Montagestege auf, mit welcher er in den Seitenwänden des Aufnahmeteils festrastbar ist.

Die US 3,160,280 offenbart eine Tragschiene, die eine Aufnahme aufweist, in welcher ein relativ schmales Modul verrastbar ist, wobei die Tragschiene einen Federsteg aufweist, um das Modul federnd relativ zur Tragschiene abzustützen.

Das Dokument US 2005/175402 A1 zeigt ein Elektronikmodul mit einem Montagefuss zum Aufsetzen auf eine Tragschiene.

Elektronikmodule der gattungsgemäßen Art sind allgemein bekannt - so als Elektronikreihenklemmen, die auf eine Tragschiene hutartiger Bauweise aufgerastet werden - und werden oftmals an Orten - beispielsweise an Schaltschränken von Werkzeugmaschinen oder dgl. - eingesetzt, an denen sie starken Vibrationen und Erschütterungen ausgesetzt sind.

Die Erfindung hat die Aufgabe, die Elektronikmodule so auszugestalten, dass die Gefahr von Beschädigungen durch solche Vibrationen verringert wird.

Die Erfindung löst diese Aufgabe durch den Gegenstand des Anspruchs 1. Vorteilhafte Ausgestaltungen der Erfindung sind den Unteransprüchen zu entnehmen.

Derart wird die Gefahr von Beschädigungen durch Erschütterungen oder Vibrationen wirksam verringert. Dabei können auch vorteilhaft zwei oder mehrere der Federelemente an dem Gehäuse ausgebildet sein.

Es ist weiter vorteilhaft und sicher, dass das Gehäuse im Bereich seiner unteren äußeren Ecken, die im montierten Zustand an der zur Montagebasis gewandten Seite des Gehäuses ausgebildet sind, jeweils eines oder mehrere der Federelemente aufweist.

Dabei ist es weiter im Sinne einer kostengünstigen und anderseits kompakten Ausgestaltung vorteilhaft, dass das wenigstens eine Federelement wenigstens einen Federsteg oder jeweils zwei oder mehrere Federstege aufweist, welcher oder welche an der zur Montagebasis gewandten Seite nach unten von dem Gehäuse vorsteht/vorstehen. und wobei der wenigstens eine Federsteg (7, 7a, 7b, 7c, ...) derart bemessen ist, dass er ständig und/oder bei Relativ-Schwingungsbewegungen an der Montagebasis (M) anliegt.

Konstruktiv können die Federelemente einfach und kostengünstig dadurch realisiert werden, dass das wenigstens eine oder mehrere oder sämtliche der Federelemente einstückig in eine Wand, insbesondere eine Seitenwand, des Gehäuses integriert ist. Alternativ können die Federelemente auch an das Gehäuse angesetzt oder angespritzt sein, beispielsweise in Form einer Elastomerfeder.

Es können auch vorteilhaft mehrere der Seitenwände des Gehäuses jeweils eines oder mehrere der Federelemente aufweisen, um eine federnde Abstützung an entsprechend mehreren verteilten Stellen zu erreichen.

Dabei sind verschiedenste Varianten von Federstegen realisierbar, von denen einige anschließend unter Bezug auf die Figuren näher erläutert werden.

Die Erfindung schafft ergänzend auch eine Anordnung aus einer Montagebasis mit einer Tragschiene und mit auf der Tragschiene angeordneten, aneinander gereihten Elektronikmodulen nach einem oder mehreren der darauf bezogenen Ansprüche.

Nachfolgend wird die Erfindung anhand von Ausführungsbeispielen unter Bezug auf die Zeichnung näher beschrieben. Es zeigt:
- Fig. 1: in a) eine perspektivische Ansicht einer Baugruppe aus aneinander gereihten erfindungsgemäßen Elektronikmodulen, die auf eine Montagebasis aufgesetzt ist und in b) eine Ansicht der Anordnung aus a) ohne Montagebasis aus einer anderen Perspektive von unten;
- Fig. 2: in a) eine perspektivische Ansicht und in b) eine Vorderansicht eines Elektronikmoduls erster Bauart aus der Baugruppe der Fig. 1 und in c) eine Ansicht der Anordnung aus a) ohne Montagebasis aus einer anderen Perspektive von unten;
- Fig. 3: in a) eine perspektivische Ansicht und in b) eine Vorderansicht eines Elektronikmoduls zweiter Bauart aus der Baugruppe der Fig. 1, das auf die Montagebasis aufgesetzt ist und in c) eine Ansicht der Anordnung aus a) ohne Montagebasis aus einer anderen Perspektive von unten;
- Fig. 4: in a) einen Eckbereich eines Elektronikmoduls erster oder zweiter Bauart und in b) den Eckbereich aus a) in einem Zustand, in dem das Elektronikmodul auf die Montagebasis aufgesetzt ist;
- Fig. 5: in a) und b), c) und d), e) und f), g) und h), i) und j), k) und l), m) und n) jeweils eine Vorderansicht und eine perspektivische Ansicht verschiedener unterer Eckbereiche für verschiedene Varianten erfindungsgemäßer Elektronikmodule; und
- Fig. 6: in a) und b) eine Vorderansicht und als Ausschnittsvergrößerung einen unteren Eckbereich eines bekannten Elektronikmoduls, das auf einer Montagebasis angeordnet ist.

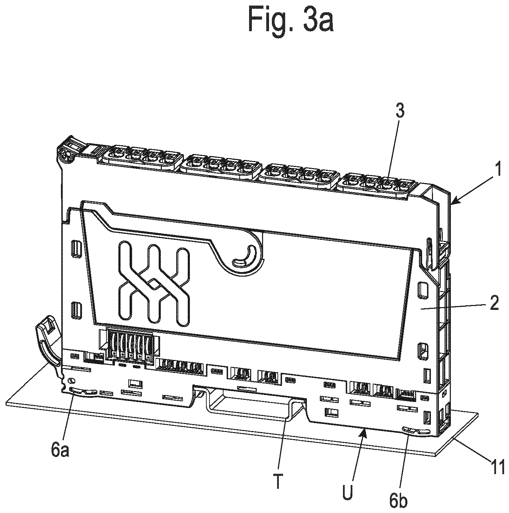

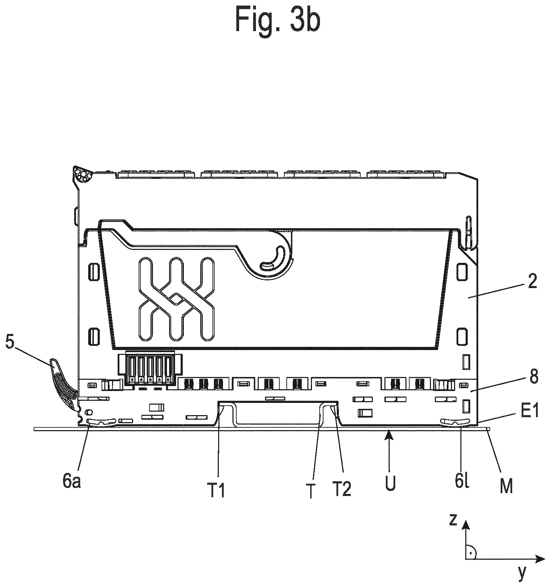

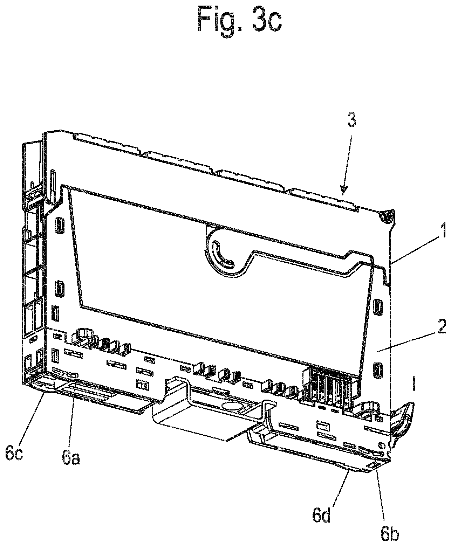

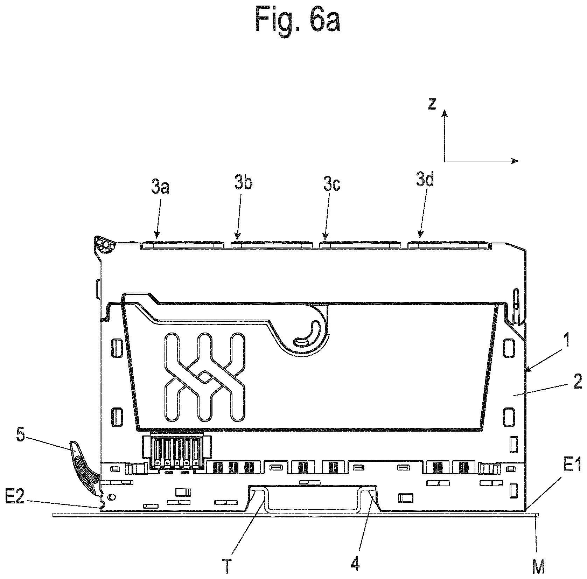

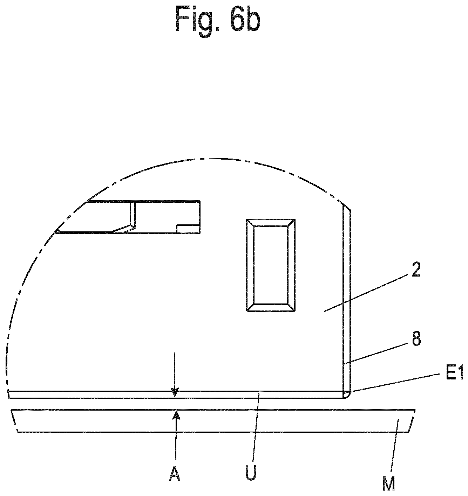

Nachfolgend wird zunächst der Grundaufbau eines bekannten Elektronikmoduls nach Fig. 6 erläutert. Ortsangaben und Begriffe wie "oben" und unten", "rechts" und links" beziehen sich auf eine untere Montagebasis M in der horizontalen Ausrichtung der Fig. 6 oder auch bezogen auf die Erfindung der Fig. 3b) und sind derart relativ bezogen zu verstehen. Am Einsatzort kann die Montagebasis M auch vertikal oder schräg ausgerichtet sein.

Das bekannte Elektronikmodul 1 weist ein mehrteiliges Gehäuse 2 auf. Dieses besteht vorzugsweise aus einem nichtleitenden Kunststoff. In ihm ist eine Funktionselektronik mit einer oder mehreren Elektronikkomponenten angeordnet. Zu diesen Elektronikkomponenten gehören im Sinne dieser Anmeldung einerseits eines oder mehrere Bauelemente wie Widerstände, Kondensatoren, Spulen, Dioden, usw. aber auch eines oder mehrere rein stromleitende Bauelemente wie Stromschienen, Leiter, Leiteranschlüsse usw.. Die Funktionselektronik kann sich somit beispielsweise auf einen oder mehrere Anschlüsse 3a, 3b, 3c, ... und eine oder mehrere Stromschienen beschränken aber auch eine oder mehrere weitere der genannten Elektronikkomponenten aufweisen. Vorzugsweise sind an dem Gehäuse 2 - hier an der Oberseite - einer oder mehrere der Anschlüsse 3a, 3b, .... für Steckelemente wie Stecker oder Leiterenden vorgesehen.

Auf der Montagebasis M ist wenigstens eine Tragschiene T angeordnet oder ausgebildet. Diese weist hier einen hutförmigen Querschnitt auf.

Das Gehäuse 2 ist an seinem unteren, zu der Tragschiene T gerichteten Bereich mit einem Montagefuß 4 versehen. Es ist auf die Tragschiene T aufgesetzt und an dieser mit Hilfe des Montagefußes 4 befestigt. Der Montagefuß 4 kann hier mittels einer Handhabe 5 über eine hier nicht zu erkennende Mechanik gelöst und verriegelt werden.

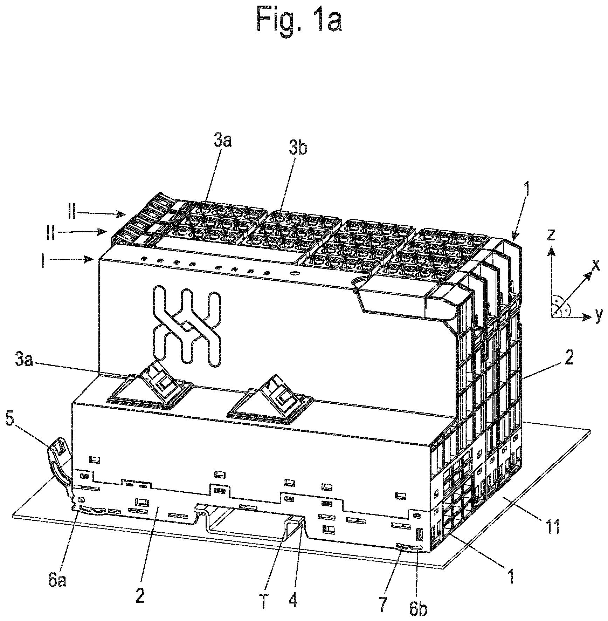

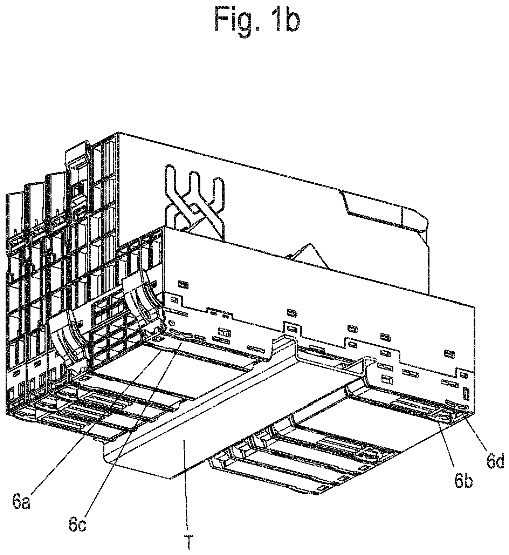

Zur näheren Beschreibung der Ausrichtung im Raum wird nachfolgend ein kartesisches Koordinatensystem X, Y, Z verwendet. Die Tragschiene T erstreckt sich hier in der X-Richtung (siehe auch Fig. 1). Die Montagebasis M liegt in der X-/Y-Ebene. Die vertikale Richtung senkrecht zur Montageebene wird mit Z bezeichnet.

Das Gehäuse 2 erstreckt sich seitlich jeweils über die Ränder T1, T2 der Tragschiene T in +Y-Richtung und/oder -Y-Richtung hinaus. Beispielhaft erstreckt es sich in Y-Richtung und/oder -Y-Richtung um 50 bis 150 mm beidseits über die Ränder T1, T2 der Tragschiene T hinaus. Die Unterseite U des Gehäuses 2, das heißt, die zur Montagebasis M gewandte Seite U, reicht nach den hier zu betrachtenden Ausgestaltungen sehr nahe an die Montagebasis M heran. Hierunter wird verstanden, dass der Abstand A (Fig. 6b) des Gehäuses (2) im montierten Zustand zu der ebenen Montagebasis M unterhalb der Tragschiene T weniger als 10 mm, insbesondere weniger als 4 mm beträgt. Wenn jetzt die seitliche Erstreckung in Y-Richtung relativ groß ist, besteht die Gefahr, dass das Gehäuse 2 bei Schwingungen der Montagebasis M und der Tragschiene T selbst in Schwingungen versetzt wird und an seiner Unterseite insbesondere im Bereich der Ecken E1 und E2 auf die Montagebasis M aufschlägt. Dies birgt wiederum die Gefahr einer Beschädigung der Funktionselektronik und/oder anderer Funktionselemente des Elektronikmoduls 1.

Die Gehäuse 2 weisen vorzugsweise Verbindungselemente auf und sind anreihbar ausgestaltet. Dies bedeutet, dass in der Haupterstreckungsrichtung X der Tragschiene mehrere der Elektronikmodule 1 aneinandergereiht werden können (siehe ergänzend die die Erfindung betreffende Fig. 1). Dazu weisen die Elektronikmodule 1 vorzugsweise einen relativ schmalen, scheibenförmigen Aufbau auf. Sie können alle gleich ausgebildet sein. Es können aber auch Elektronikmodule 1 verschiedenen Typs I und II vorgesehen sein. Diese können verschieden breit sein (insbesondere in X-Richtung) und insbesondere in ihrem oberen von der Tragschiene abgewandten Bereich verschieden ausgestaltet sein. So zeigt Fig. 1 ein Elektronikmodul 1 ersten Typs I, das als Feldbuskoppler ausgebildet ist. Daran sind Elektronikmodule eines zweiten Typs II angereiht, die hier beispielhaft als I-/O-Module ausgebildet sind, aber auch eine andere Funktionalität aufweisen können.

Erfindungsgemäß kann und wird vorzugsweise die vorstehend beschriebene Ausgestaltung beibehalten werden. Anders als in Fig. 6a und b ist aber nach der Erfindung im unteren Bereich des Gehäuses jedes erfindungsgemäßen Elektronikmoduls 1 wenigstens ein Federelement 6 ausgebildet oder angeordnet. Vorzugsweise ist das Federelement 6 in das Gehäuse 2 integriert und einstückig mit diesem ausgebildet. Diese Ausgestaltung ist einfach, kostengünstig und funktionssicher. Nach einer anderen Variante kann das wenigstens eine Federelement & aber auch ein separates Federelement nach Art eines Elastomers oder einer Metall- oder Kunststofffeder (z.B. nach Art einer Blattfeder) sein, dass an die Unterseite des Gehäuses angesetzt ist (hier nicht dargestellt).

Aufgrund der günstigen Kosten und des geringen Bauraumbedarfs wird die Variante, nach welcher das Federelement 6 einstückig mit dem Gehäuse 2 ausgebildet ist bzw. in dieses integriert ist, bevorzugt.

Nachfolgend wird jeweils ein einzelnes der Federelemente 6 beschrieben. An einem erfindungsgemäßen Elektronikmodul ist wenigstens eins oder sind vorzugsweise zwei oder mehr (vorzugsweise vier) oder sogar noch mehr dieser Federelemente 6 ausgebildet. Besonders bevorzugt ist eine Ausgestaltung mit vier Federelementen 6a, 6b, von denen jeweils zwei Federelemente 6a, 6c bzw. 6b, 6d im Bereich der beiden unteren Eckbereiche E1 und E2 bzw. nahe zu diesen Eckbereichen (beidseits der Tragschiene T, hier an jeder Seite des Elektronikmoduls) an der Unterseite U des Gehäuses 2 ausgebildet sind. Das Elektronikmodul vom Typ II weist sogar acht der Federelemente auf. Das Elektronikmodul vom Typ II weist hier vorzugsweise vier der Federelemente 6 auf.

Die Eckbereiche sind nach der Fig.1 die Bereiche, die am ehesten an die Montagebasis M anschlagen. Dies ist aber nicht zwingend sondern resultiert auf dem dargestellten bevorzugten Aufbau der erfindungsgemäßen Gehäuse, nach welchem die Unterseite der Gehäuse 2 seitlich der Tragschiene T jeweils im Wesentlichen bis auf die Federelemente 6 eben ist. Bei einer gestuften Ausbildung der Unterseite des Gehäuses 2 kann es aber auch sinnvoll sein, an anderer Stelle wenigstens eines des Federelemente 6 vorzusehen (Hier nicht dargestellt).

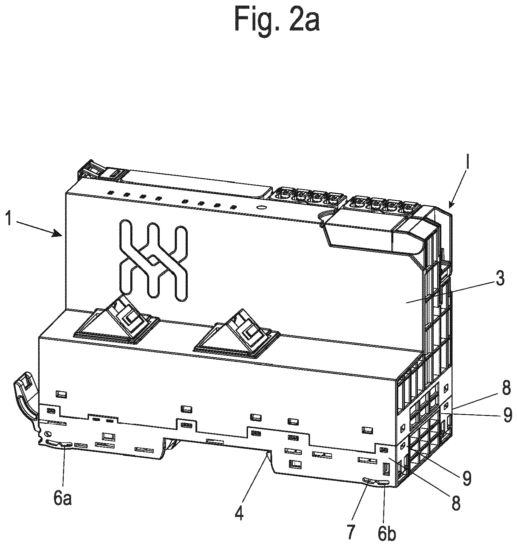

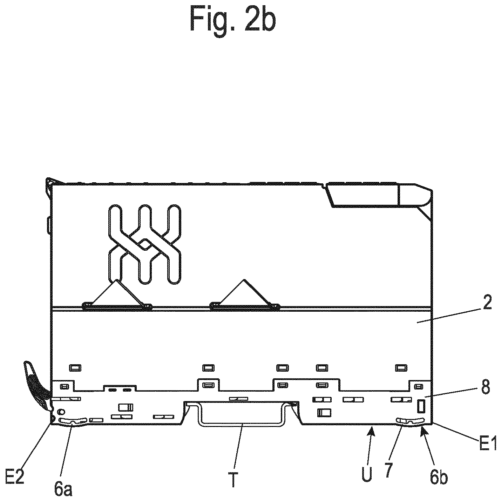

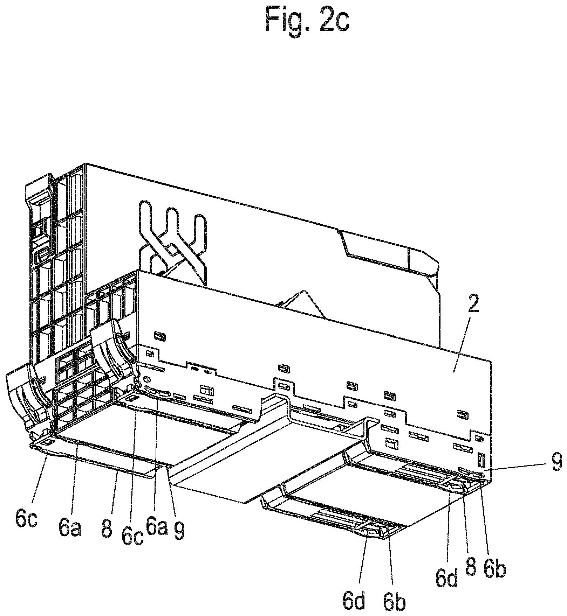

Jedes der Gehäuse 2 der anliegenden Figuren 1 bis 5 (und 6) weist einen hier im Wesentlichen in der Seitenansicht der Fig.1 rechteckigen Aufbau auf. Die ist vorteilhaft, aber nicht zwingend. Jedes Gehäuse 2 weist eine Unterseite U auf, die im eingebauten Zustand zu einer Montagebasis M hin gerichtet ist. Diese Montagebasis M ist beispielsweise eine Schaltschrankwand. Für die nachfolgenden Betrachtungen wird diese Montagebasis M als Ebene betrachtet.

Das bevorzugte, jeweils-in den Eckbereichen E1 und E2 an der Unterseite U des Gehäuses 2 ausgebildete Federelement 6, 6a, 6b, ... wird hier jeweils dadurch gebildet, dass das Gehäuse 2 im Bereich jedes Federelementes 6 wenigstens einen der Federstege 7 aufweist. Dieser Federsteg 7 steht wie ein Vorsprung über die benachbarte Unterkante der Unterseite U des Gehäuses 2 in diesem Bereich nach unten (in Richtung der Montagebasis M) hin vor. Das oder die Federelemente 6 mit dem Federsteg 7 ist/sind vorzugsweise jeweils an einer oder an beiden oder noch mehreren Haupt-Seitenwänden 8, 9 des Gehäuses 2 ausgebildet und kostengünstig und einfach einstückig in diese integriert.

Dies wird besonders gut aus den Abbildungen 1b, 2c und 3c deutlich. Die Haupt-Seitenwände 8, 9 sind insbesondere die anzureihenden Wände des Gehäuses 2, die in der Y-/Z-Ebene liegen. Der Federsteg 7 wird vorzugsweise in diese Seitenwände intergiert. Es ist aber auch denkbar, ihn in der unteren Wand oder an den kurzen Seitenwänden des Gehäuses 2 auszubilden, welche die Haupt-Seitenwände 8 und 9 verbinden (hier jeweils nicht dargestellt).

Es ist auch denkbar, dass ein Elektronikmodul mehr als zwei der Seitenwände aufweist, die mit einem oder mehreren Federelementen 6 versehen sind. Dies kann beispielsweise dann der Fall sein, wenn das Elektronikmodul eine sehr große Baubreite aufweist, z.B. wenn es eine mehrfache Rasterbreite in Richtung X aufweist, die hier durch die Breite des Elektronikmodul zweiter Bauart - Bezugszeichen II - definiert ist. So weist das Elektronikmodul erster Bauart - Bezugszeichen I - beispielhaft vier Seitenwände - zwei äußere Hauptseitenwände und zwei in Richtung X weiter innen liegende Zwischen-Seitenwände -, die aber im Sinne dieser Anmeldung allesamt als Hauptseitenwände bezeichnet werden und die hier auch jeweils mit Federelementen 6 mit einem oder mehreren Federsteg(en) 7 versehen sind. Dies veranschaulicht insbesondere Fig. 1c.

Es kann nur in einer oder es können in beiden der Wände, insbesondere der Haupt-Seitenwände 8, 9, eines oder mehrere der Federelemente 6 ausgebildet sein. Vorzugsweise ist jede der beiden Haupt-Seitenwände 8, 9 mit jeweils zwei Federstegen 7 versehen, und zwar nahe zu den unteren äußeren Ecken E1 und E2.

Dabei könnten die Federstege 7 auch miteinander durch einen Steg in X Richtung verbunden sein (hier nicht dargestellt). Es ist auch denkbar, dass nur drei Federelemente 6 vorgesehen sind, so zwei an den Ecken E1 und eines an einer der Ecken E2 (hier nicht dargestellt). Denkbar ist zudem bei ebenfalls erfindungsgemäßen aber etwas weniger bevorzugten Ausgestaltungen, dass nur eins oder zwei Federelemente 6 vorgesehen sind, so eines an einer der Ecken E1 und eines an einer der diagonal gegenüber liegende Ecke E2 (hier nicht dargestellt). Derart wird auch bereits eine verbesserte Sicherung gegen Erschütterungen geschaffen, die aber durch weitere Federelemente 6 noch weiter ergänzt werden kann. Denkbar ist schließlich auch, dass eines der Federelemente 6 in den Montagefuß 4 oder eine Bodenwand integriert ist (oder auf sonstige Weise an dem Gehäuse ausgebildet ist (hier jeweils nicht dargestellt)).

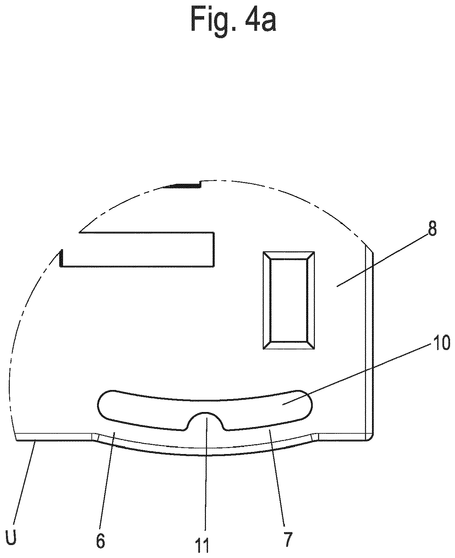

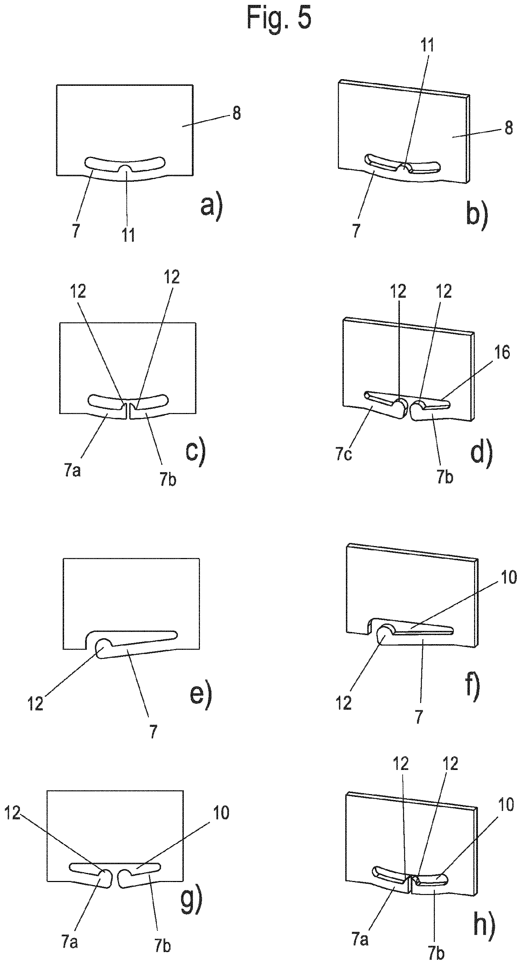

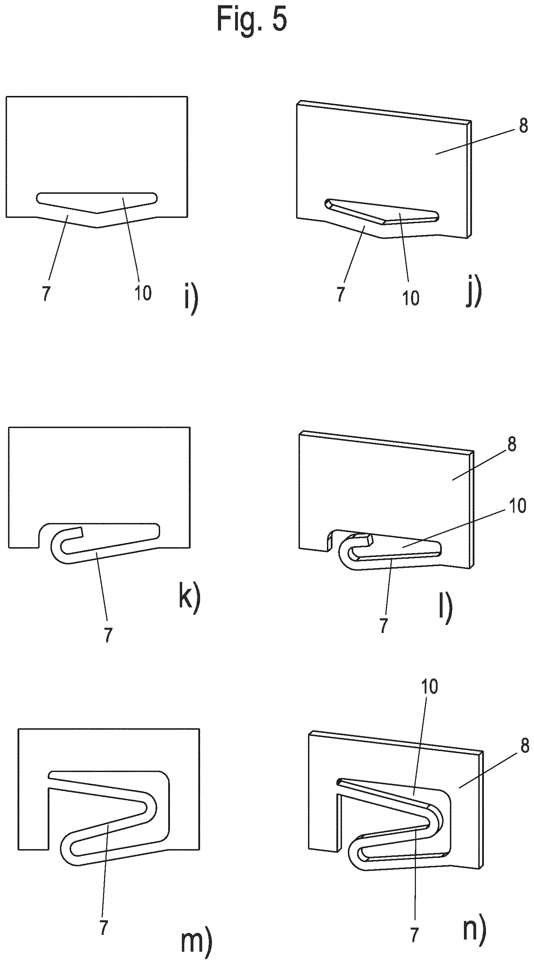

Der wenigstens eine Federsteg 7 ist (siehe Fig. 4a sowie 5) an einem oder an zwei Enden einstückig mit dem Gehäuse 2, insbesondere der jeweiligen Seitenwand 8 oder 9 verbunden bzw. ausgebildet. Oberhalb des Federsteges 7 ist ein fensterartiger Durchbruch (der auch ein Ausschnitt sein kann) in der zugehörigen Seitenwand 9 des Gehäuses 2 ausgebildet. Dieser Durchbruch kann als Langloch 10 ausgebildet sein, insbesondere als bogenförmiges Langloch. Dann ist es vorteilhaft, wenn der Federsteg 7 ebenfalls eine Bogenform aufweist, wobei er in seinem mittleren Bereich am weitesten von der benachbarten Unterkante des Gehäuses 2 vorsteht bzw. am nächsten zu der Montagebasis M liegt (Fig.1 bis 4, 5a und 5b, 5a und 5d).

Vorzugsweise - aber nicht zwingend - ist der Durchbruch als ein schmales Langloch 10 ausgebildet, dass nur ca. 1 bis 3 mm breit ist (in Z-Richtung). Schlägt das Gehäuse 2 im Bereich des jeweiligen Federsteges 7 infolge von Schwingungen an die Montagebasis M an, kann er in den Durchbruch, insbesondere in das Langloch, einfedern. Dabei dämpft der Federsteg 7 die Erschütterung. Hierdurch werden das gesamte Elektronikgehäuse und insbesondere dessen Funktionselektronik wirksam gegen eine Beschädigung durch Erschütterungen geschützt.

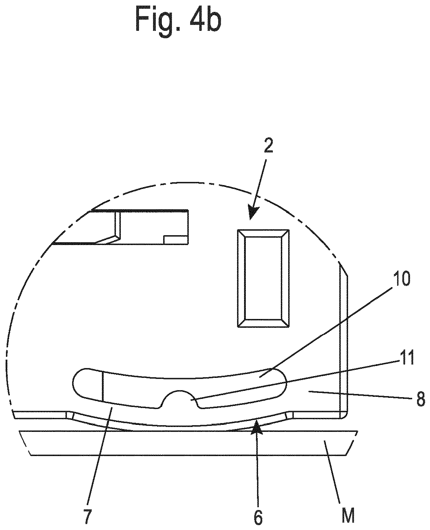

Der Federsteg 7 kann wiederum selbst einen Vorsprung 11 aufweisen, der sich von der Oberkante des Federsteges 7 etwas in den Durchbruch, insbesondere das Langloch 10, vorsteht. Hierdurch kann die Federcharakteristik einfach beeinflusst und eingestellt werden. Der Federsteg 7 kann an unterster Stelle noch einen Abstand zur Montagebasis aufweisen und nur im Falle von Erschütterungen an dieser anliegen oder bereits in einem Ruhezustand ohne Erschütterungen auf dieser aufliegen (Fig. 4b).

Fig. 5 zeigt verschieden ausgestaltete Federelemente 6. Dargestellt ist jeweils nur ein unterer Eckausschnitt einer Seitenwand 8 oder 9 eines Gehäuses 2 mit jeweils einem der Federelemente 6.

Das jeweilige Federelement 6 kann einen einzigen Federsteg 7 aufweisen (Fig. 5 a und b, e und f, i und j, k und l, m und n) oder zwei Federstege 7a, 7b (Fig. 5c und d, g und h) oder mehr als zwei Federstege (hier nicht dargestellt).

Dabei kann jeder der Federstege 7, 7a, 7b nur an einem seiner Enden (Fig. 5c und d, e und f, g und h, k und l, m und n) oder an zwei Enden (Fig. 5a und b, i und j) mit der Seitenwand 8 verbunden sein.

Auch der Durchbruch 10 kann auf verschiedene Weise ausgestaltet sein. Er kann eine Bogenform aufweisen (Fig. 5a und b, c und d) oder auch eine andere Form, die ein Einfedern des einen oder der mehreren Federstege 7a, 7b erlaubt, so beispielsweise eine Dreieckform (Fig. 5 i und j).

Wenn die Federstege 7a, 7b, ... nur mit einem ihrer Enden mit der zugehörigen Seitenwand 8, 9 verbunden sind, ist es vorteilhaft, wenn sie am Ende eine Art Hammerkopf 12 als den Vorsprung 11 aufweisen, welcher sich in den Durchbruch hinein erstreckt und welcher den Federweg begrenzt und die Federcharakteristik beeinflusst (Fig. 5c und d, e und f, g und h, k und l). Der Hammerkopf kann massiv ausgebildet sein oder als Bogen (Fig. K und l) oder Haken.

Der Federsteg 7a, 7b, .... kann auch als, bis auf den ggf. vorgesehenen Hammerkopf, gerader Steg (Fig. 5e und f, k und l) oder als in sich gewinkelter Steg (Fig. 5i und j, m und n) ausgebildet sein.

**Bezugszeichen**

| | |
|---|---|
| Elektronikmodul | 1 |
| Gehäuse | 2 |
| Anschlüsse | 3a, 3b, 3c, |
| Montagefuß | 4 |
| Handhabe | 5 |
| Federelement | 6, 6a, 6b, |
| Federsteg | 7, 7a, 7b |
| Haupt-Seitenwände | 8, 9 |
| Langloch | 10 |
| Vorsprung | 11 |
| Hammerkopf | 12 |
| Montagebasis | M |
| Tragschiene | T |
| Koordinatensystem | X, Y, Z |
| Tragschienenränder | T1, T2 |
| Gehäuse-Unterseite | U |
| Ecken | E1 und E2 |

## Patentansprüche

1. Elektronikmodul mit einem Gehäuse (2) mit einem Montagefuß (4) zum Aufsetzen auf eine Tragschiene (T), und zum Befestigen des Elektronikmoduls an der Tragschiene (T), wobei das Gehäuse (2) an seinem unteren, im montierten Zustand zu der Tragschiene (T) gewandten Bereich mit dem Montagefuß versehen ist, wobei die Tragschiene (1) auf einer Montagebasis (M) angeordnet ist, wobei im unteren, im montierten Zustand zur Montagebasis gewandten Bereich des Gehäuses (2) wenigstens ein Federelement (6) ausgebildet ist, das derart bemessen und ausgelegt ist, dass es bei Schwingungsbewegungen des Gehäuses (2) relativ zur Montagebasis (M) dämpfend wirkt, **dadurch gekennzeichnet, dass** das wenigstens eine oder die Federelemente (6) beabstandet zum Montagefuß (3) des Gehäuses (2) angeordnet ist/sind, und dass das Gehäuses im Bereich seiner unteren äußeren Ecken (E1, E2), die im montierten Zustand an der zur Montagebasis (M) gewandten Seite des Gehäuses (2) ausgebildet sind - oder nahe zu diesen Ecken - jeweils eines oder mehrere der Federelemente (6) aufweist, wobei das wenigstens eine Federelement (6) wenigstens einen Federsteg (7, 7a, 7b, 7c, ...) aufweist, welcher an der zur Montagebasis (M) gewandten Seite nach unten von dem Gehäuse (2) vorsteht und wobei der wenigstens eine Federsteg (7, 7a, 7b, 7c, ...) derart bemessen ist, dass er ständig und/oder bei Relativ-Schwingungsbewegungen an der Montagebasis (M) anliegen kann.

2. Elektronikmodul nach Anspruch 1, **dadurch gekennzeichnet, dass** der Montagefuß (4) mittels einer Handhabe (4) über eine Mechanik gelöst und verriegelt werden kann.

3. Elektronikmodul nach Anspruch 1 oder 2, **dadurch gekennzeichnet, dass** zwei oder mehr der Federelemente (6) an dem Gehäuse (2) ausgebildet sind.

4. Elektronikmodul nach einem der vorstehenden Ansprüche 1, 2 oder 3, **dadurch gekennzeichnet, dass** das wenigstens eine oder mehrere oder sämtliche der Federelemente (6) einstückig in eine Wand, insbesondere eine Seitenwand (8, 9), des Gehäuses (2) integriert ist.

5. Elektronikmodul nach einem der vorstehenden Ansprüche, **dadurch gekennzeichnet, dass** das wenigstens eine Federelement (6) oder mehrere der Federelemente (6) jeweils zwei oder mehrere der Federstege (7, 7a, 7b, 7c, ...) aufweist.

6. Elektronikmodul nach einem der vorstehenden Ansprüche, **dadurch gekennzeichnet, dass** der wenigstens eine Federsteg (7, 7a, 7b, ...) an einem oder beiden Enden mit einer Seitenwand des Gehäuses (2) einstückig verbunden ist.

7. Elektronikmodul nach Anspruch 6, **dadurch gekennzeichnet, dass** der wenigstens eine Federsteg (7, 7a, 7b, ...) mit einer in einer Anreihrichtung liegenden Haupt-Seitenwand (8, 9) des Gehäuses (2) einstückig verbunden ist.

8. Elektronikmodul nach einem der vorstehenden Ansprüche, **dadurch gekennzeichnet, dass** an jeder der beiden in den zwei Anreihrichtungen liegenden Haupt-Seitenwände (8, 9) des Gehäuses (2) eines oder mehrere der Federelemente (6) mit jeweils wenigstens einem oder mehreren der Federstege (7, 7a, 7b, ...) vorgesehen ist.

9. Elektronikmodul nach einem der vorstehenden Ansprüche, **dadurch gekennzeichnet, dass** oberhalb des einen Federsteges /7, 7a, 7b, ...) oder der mehreren Federstege ein fensterartiger Durchbruch in der zugehörigen Seitenwand (8, 9) des Gehäuses 2 ausgebildet ist, der derart ausgelegt ist, dass der jeweilige Federsteg (7) in den Bereich des Langloches (10) einfedern kann.

10. Elektronikmodul nach Anspruch 9, **dadurch gekennzeichnet, dass** der Durchbruch als Langloch (10) ausgebildet ist, insbesondere als bogenförmiges oder dreieckiges Langloch, das derart ausgelegt ist, dass der Federsteg (7) in den Bereich dieses Langloches (10) einfedern kann.

11. Elektronikmodul nach einem der vorstehenden Ansprüche 9 oder 10, **dadurch gekennzeichnet, dass** der Federsteg (7) einen Vorsprung (11) aufweist, der von der Oberkante des Federsteges etwas in den Durchbruch, insbesondere das Langloch (10), vorsteht.

12. Elektronikmodul nach einem der vorstehenden Ansprüche, **dadurch gekennzeichnet, dass** der Federsteg (7) einen Hammerkopf (12) aufweist.

13. Elektronikmodul nach einem der vorstehenden Ansprüche, **dadurch gekennzeichnet, dass** der Federsteg (7) eine Bogenform aufweist oder gerade oder in sich winklig ausgebildet ist.

14. Anordnung aus einer Montagebasis (M) mit einer Tragschiene (T) und mit auf der Tragschiene angeordneten, aneinander gereihten Elektronikmodulen nach einem oder mehreren der vorstehenden Ansprüche.

## Claims

1. Electronics module comprising a housing (2) having a mounting foot (4) for placing on a support rail (T) and for fastening the electronics module to the support rail (T), wherein the housing (2) is provided with the mounting foot on its lower region facing the support rail (T) in the mounted state, wherein the mounting rail (1) is arranged on a mounting base (M), wherein at least one spring element (6) is formed in the lower region of the housing (2) facing the mounting base in the mounted state, which spring element (6) is dimensioned and designed in such a manner that it acts in a damping manner in the event of oscillatory movements of the housing (2) relative to the mounting base (M), **characterized in that** the at least one or the spring elements (6) is/are arranged at a distance from the mounting foot (3) of the housing (2), and **in that** the housing comprises in each case one or a plurality of the spring elements (6) in the region of its lower outer corners (E1, E2), which in the assembled state are formed on the side of the housing (2) facing the mounting base (M) - or close to these corners -, wherein the at least one spring element (6) has at least one spring bar (7, 7a, 7b, 7c, ...) which protrudes downwards from the housing (2) on the side facing the mounting base (M), and wherein the at least one spring bar (7, 7a, 7b, 7c, ...) is dimensioned in such a way that it can rest against the mounting base (M) continuously and/or during relative oscillatory movements.

2. Electronics module according to claim 1, **characterized in that** the mounting foot (4) can be released and locked by means of a handle (4) via a mechanism.

3. Electronics module according to claim 1 or 2, **characterized in that** two or a plurality of the spring elements (6) are formed on the housing (2).

4. Electronics module according to one of the preceding claims 1, 2 or 3, **characterized in that** the at least one or a plurality or all of the spring elements (6) are integrated integrally into a wall, in particular a side wall (8, 9), of the housing (2).

5. Electronics module according to one of the preceding claims, **characterized in that** the at least one spring element (6) or a plurality of the spring elements (6) each has two or more of the spring bars (7, 7a, 7b, 7c, ...).

6. Electronics module according to one of the preceding claims, **characterized in that** the at least one spring bar (7, 7a, 7b, ...) is integrally connected at one end or both ends to a side wall of the housing (2).

7. Electronics module according to claim 6, **characterized in that** the at least one spring bar (7, 7a, 7b, ...) is integrally connected to a main side wall (8, 9) of the housing (2) disposed in a line-up direction.

8. Electronics module according to one of the preceding claims, **characterized in that** one or more of the spring elements (6) is provided with in each case at least one or a plurality of the spring bars (7, 7a, 7b, ...) on each of the two main side walls (8, 9) of the housing (2) disposed in the two line-up directions.

9. Electronics module according to one of the preceding claims, **characterized in that** above the one spring bar (7, 7a, 7b, ...) or the plurality of spring bars, a window-like opening is formed in the associated side wall (8, 9) of the housing 2, which is designed in such a way that the respective spring bar (7) can be deflected into the region of the slot (10).

10. Electronics module according to claim 9, **characterized in that** the opening is designed as a slot (10), in particular as an arcuate or triangular slot, which is designed in such a way that the spring bar (7) can be deflected into the region of this slot (10).

11. Electronics module according to one of the preceding claims 9 or 10, **characterized in that** the spring bar (7) has a projection (11) which projects slightly from the upper edge of the spring bar into the opening, in particular the slot (10).

12. Electronics module according to one of the preceding claims, **characterized in that** the spring bar (7) has a hammer head (12).

13. Electronics module according to one of the preceding claims, **characterized in that** the spring bar (7) has a curved shape or is designed straight or angular in itself.

14. Arrangement consisting of a mounting base (M) having a support rail (T) and having electronics modules arranged on the support rail next to each other in a row, according to one or more of the preceding claims.

## Revendications

1. Module électronique avec un boîtier (2) muni d'un pied de montage (4) pour le poser sur un rail porteur (T) et fixer le module électronique sur le rail porteur (T), dans lequel le boîtier (2) est muni du pied de montage dans sa partie inférieure tournée vers le rail porteur (T) dans l'état monté, dans lequel le rail porteur (1) est disposé sur une base de montage (M), dans lequel est formé dans la partie inférieure du boîtier (2) tournée vers la base de montage dans l'état monté au moins un élément de ressort (6) dimensionné et conçu de façon à avoir une action d'amortissement lors de mouvements d'oscillation du boîtier (2) par rapport à la base de montage (M), **caractérisé en ce que** l'au moins un ou les éléments de ressort (6) sont disposés à distance du pied de montage (3) du boîtier (2) et **en ce que** le boîtier présente au niveau de chacun de ses angles extérieurs inférieurs (E1, E2) un ou plusieurs des éléments de ressort (6) formés sur le côté du boîtier (2) tourné vers la base de montage (M) ou près de ces angles dans l'état monté, l'au moins un élément de ressort (6) présentant au moins une barrette de ressort (7, 7a, 7b, 7c, ...) qui dépasse du boîtier (2) vers le bas sur le côté tourné vers la base de montage (M) et l'au moins une barrette de ressort (7, 7a, 7b, 7c, ...) étant dimensionnée de façon à pouvoir reposer constamment et/ou lors de mouvements d'oscillation relative sur la base de montage (M).

2. Module électronique selon la revendication 1, **caractérisé en ce que** le pied de montage (4) peut être débloqué et verrouillé à l'aide d'un mécanisme au moyen d'un organe de manipulation (4).

3. Module électronique selon la revendication 1 ou 2, **caractérisé en ce que** deux des éléments de ressort (6) ou plus sont formés sur le boîtier (2).

4. Module électronique selon l'une des revendications 1, 2 ou 3, **caractérisé en ce que** l'au moins un ou plusieurs ou tous les éléments de ressort (6) sont intégrés d'un seul tenant dans une paroi, en particulier une paroi latérale (8, 9), du boîtier (2).

5. Module électronique selon l'une des revendications précédentes, **caractérisé en ce que** l'au moins un élément de ressort (6) ou plusieurs des éléments de ressort (6) présentent chacun deux ou plusieurs des barrettes de ressort (7, 7a, 7b, 7c, ...).

6. Module électronique selon l'une des revendications précédentes, **caractérisé en ce que** l'au moins une barrette de ressort (7, 7a, 7b, ...) est reliée d'un seul tenant à une paroi latérale du boîtier (2) à une extrémité ou aux deux.

7. Module électronique selon la revendication 6, **caractérisé en ce que** l'au moins une barrette de ressort (7, 7a, 7b, ...) est reliée d'un seul tenant à une paroi latérale principale (8, 9) du boîtier (2) orientée dans une direction d'alignement.

8. Module électronique selon l'une des revendications précédentes, **caractérisé en ce que** sont prévus sur les deux parois latérales principales (8, 9) du boîtier (2) orientées dans les deux directions d'alignement un ou plusieurs des éléments à ressort (6) munis d'au moins une ou de plusieurs des barrettes de ressort (7, 7a, 7b, ...).

9. Module électronique selon l'une des revendications précédentes, **caractérisé en ce qu'**une découpe formant une fenêtre est formée dans la paroi latérale (8, 9) correspondante du boîtier (2) au-dessus de la barrette de ressort (7, 7a, 7b, ...) ou des plusieurs barrettes de ressort et conçue de telle manière que la barrette de ressort (7) correspondante puisse faire passer dans la région du trou oblong (10) pendant son mouvement de ressort.

10. Module électronique selon la revendication 9, **caractérisé en ce que** la découpe est conformée comme un trou oblong (10), en particulier un trou oblong en arc de cercle ou triangulaire, qui est conçu de telle manière que la barrette de ressort (7) puisse passer dans la région de ce trou oblong (10) pendant son mouvement de ressort.

11. Module électronique selon l'une des revendications 9 ou 10, **caractérisé en ce que** la barrette de ressort (7) présente une saillie (11) qui dépasse du bord supérieur de la barrette de ressort à peu près dans la découpe, en particulier dans le trou oblong (10).

12. Module électronique selon l'une des revendications précédentes, **caractérisé en ce que** la barrette de ressort (7) présente une tête en forme de marteau (12).

13. Module électronique selon l'une des revendications précédentes, **caractérisé en ce que** la barrette de ressort (7) est en forme d'arc de cercle ou rectiligne ou angulée.

14. Disposition formée d'une base de montage (M) avec un rail porteur (T) et de modules électroniques selon une ou plusieurs des revendications précédentes disposés sur le rail porteur et alignés les uns avec les autres.
